Europäisches Patentamt

European Patent Office

Office européen des brevets

(11) Publication number: **0 552 734 A2**

# EUROPEAN PATENT APPLICATION

(21) Application number: **93100798.3**

(22) Date of filing: **20.01.93**

(51) Int. Cl.5: **H03K 19/0944**

(30) Priority: **20.01.92 JP 7023/92**
**26.02.92 JP 39836/92**

(43) Date of publication of application:
**28.07.93 Bulletin 93/30**

(84) Designated Contracting States:
**DE FR GB**

(71) Applicant: **NEC CORPORATION**
**7-1, Shiba 5-chome Minato-ku**
**Tokyo 108-01(JP)**

(72) Inventor: **Yamashina, Masakazu, c/o NEC**
**Corporation**
**7-1, Shiba 5-chome**
**Minato-ku, Tokyo(JP)**

(74) Representative: **Glawe, Delfs, Moll & Partner**
**Patentanwälte**
**Postbox 26 01 62**
**W-8000 Munich 26 (DE)**

(54) **High speed logic circuit having a reduced number of critical path gate stages.**

(57) An elementary logic circuit suitable for applications for a high-speed, large-scaled integrated circuit, comprises first and second NMOS transistors connected in series between a first pair of input terminals for a first pair of complementary logic signals, and third and fourth NMOS transistors connected in series between the first pair of input terminals. A second pair of complementary logic signals are supplied to gate electrodes of the first and fourth NMOS transistors and gate electrodes of the second and third NMOS transistors, respectively. An exclusive-OR signal is outputted from a connection node between the first and second NMOS transistors, and an exclusive-NOR signal is outputted from a connection node between the third and fourth NMOS transistors.

FIGURE 1A

## Background of the Invention

### Field of the invention

The present invention relates to a high speed logic circuit, and more specifically to an elementary logic circuit suitable for a large-scale semiconductor integrated circuit which requires a binary signal and its inverted signal for an operation of the integrated circuit.

### Description of related art

Most of semiconductor integrated circuits, which have been actually put in practical use, have a structure in that a binary signal is always used together with its inverted signal, such as a decoded signal from an address decoder circuit in a memory integrated circuit, an instruction decoded signal from a control circuit in a microprocessor integrated circuit, or a booth circuit output signal of a multiplier in a digital signal processor integrated circuit. In order to cause these semiconductor integrated circuits to function, it it necessary to execute a logic operation of these signals.

For example, a typical elementary logic circuit used in a conventional semiconductor integrated circuit for outputting an exclusive logical sum (EX-OR) and its negation (EX-NOR), comprises a transfer gate constituted of a PMOS transistor and an NMOS transistor which have their source electrodes connected to each other and their drain electrodes connected to each other, and a pass transistor circuit constituted of a PMOS transistor and an NMOS transistor connected in series. The transfer gate has its input side electrode connected to gate electrodes of the two MOS transistors of the pass transistor circuit, and a first input terminal for a first input signal (called an "input signal A") is connected to a connection node between the transfer gate and the gate electrodes of the two MOS transistors. Further, a gate electrode of the PMOS transistor of the transfer gate is connected to one electrode of the PMOS transistor of the pass transistor circuit, and a second input terminal for a second input signal (called an "input signal B") is connected to a connection node between the PMOS transistor of the transfer gate and the PMOS transistor of the pass transistor circuit. A gate electrode of the NMOS transistor of the transfer gate is connected to one electrode of the NMOS transistor of the pass transistor circuit, and a signal complementary to the input signal B supplied to a third input terminal is propagated to a connection node between the the NMOS transistor of the transfer gate and the NMOS transistor of the pass transistor circuit. An output side electrode of the transfer gate is connected to a series-connection node between the two MOS transistors of the pass transistor circuit, and a signal on the series-connection node is inverted and amplified by a first inverter and outputted from a first output terminal as an output signal EX-NOR. The signal propagated to the input terminal of the first inverter is inverted, re-inverted and amplified by second and third inverters and outputted from a second output terminal as an output signal EX-OR. The three inverters not only invert or re-invert their input signals in order to match the logic, but also function as a buffer for causing a logic circuit of the following stages (not shown) connected to the first and second output terminals to operate at a sufficiently high speed. Thus, these inverters are indispensable for the high speed operation of an integrated circuit. In addition, the input signal A and the input signal B and [heir complementary signals are required for the operation of the integrated circuit as mentioned above.

In this logic circuit, the conducting conditions of the MOS transistors of the transfer gate are controlled by the input signal B and its inverted signal, respectively, and the conducting conditions of the two MOS transistors of the pass-transistor circuit are controlled by the input signal A. Thus, the logic circuit performs an exclusive logical sum (exclusive-OR) operation of the input signals A and B.

Now, if the input signal A and B are "1" and "0" respectively, the two MOS transistors of the transfer gate and the NMOS transistor of the pass-transistor circuit are turned on, and the PMOS transistor of the pass-transistor circuit is turned off. Therefore, the signal "1" supplied to the first input terminal is outputted through the transfer gate and the second and third inverters to the second output terminal. Further, the signal "1" supplied to the third input terminal is outputted through the NMOS transistor of the pass-transistor circuit to the second output terminal. If the both of the input signals A and B are "1", a signal "0" is outputted to the second output terminal and a signal "1" is outputted to the first output terminal. If the input signals A and B are "0" and "1", respectively, a signal "1" is outputted to the second output terminal and a signal "0" is outputted to the first output terminal. If both of the input signals A and B are "0", a signal "0" is outputted to the second output terminal and a signal "1" is outputted to the first output terminal.

Here, considering a critical path which determines the signal propagation speed, it is a path which passes from the respective input terminals through the MOS transistors and leads through the second and third inverters to the second output terminal for EX-OR.

The conventional logic circuit mentioned above requires a buffer in order to obtain a logic signal and its inverted signal with one circuit and also in order to operate the logic circuit of the following stage at a sufficiently high speed. Thus, the number of critical-path gate stages from the input terminal to the output terminal is large, and the number of transistors for constituting the logic circuit become also correspondingly large. Therefore, an integrated circuit using this conventional logic circuit is difficult to achieve a higher operation speed and a low power dissipation.

Summary of the Invention

Accordingly, it is an object of the present invention to provide a logic circuit which has overcome the above mentioned defect of the conventional one.

Another object of the present invention is to provide a logic circuit which is suitable for a superhigh speed large-scale integrated circuit, which has a simple circuit structure and a small number of gate stages until a logic output, and which make it easy to use a driving circuit having a large load driving capacity.

The above and other objects of the present invention are achieved in accordance with the present invention by a logic circuit comprising at least one pass-transistor circuits composed of two transistors connected in series between a pair of input signal terminals, a pair of logic signals being supplied to opposite end of the pass-transistor circuit, and a connection node between the two transistors of the pass-transistor circuit constituting an output node for generating an output logic signal, and respective control electrodes of the two transistors of the pass-transistor circuit being connected to receive a pair of complementary logic signals so that conducting conditions of the two transistors are controlled by the pair of complementary logic signals, respectively.

According to a second aspect of the present invention, there is provided a logic circuit comprising two pass-transistor circuits each composed of two transistors connected in series between a pair of input signal terminals, the transistors of one pass transistor circuit being combined with the transistors of; the other pass transistor circuit, respectively, to form two transistor pairs, signals complementary to each other being supplied to the signal input terminals of one pass-transistor circuit and the signal input terminals of the other pass-transistor circuit, and conducting conditions of the two transistor pairs being controlled by signals complementary to each other, respectively.

With the above mentioned arrangement, for example, a pair of signals consisting of an input signal A and its inverted signal $\overline{A}$ are supplied to the pass-transistor circuits composed of two MOS transistors connected in series between a pair of signal input terminals, and the conducting conditions of the two MOS transistors are controlled by another pair of signals (an input signal B and its inverted signal $\overline{B}$), so that an exclusive logical sum between the input signal A and the input signal B is obtained. In the same way, the other pass-transistor circuit is used in such a manner that the transistors of the other pass-transistor circuit are controlled by the same input signal B and its inverted signal to obtain a negation of the exclusive logical sun, at the same time. Namely, the use of the inverted signal of the input signal A, which has not been used in the conventional logic circuit, permits it to simplify the structure of the logic circuit as well as to obtain at the same time a logic signal and its negation logic signal which have their rising and their falling well in synchronism with each other.

Further, a pair of signals consisting of the input signals A and B or a pair of signals consisting of the respective inverted signals of the input signals A and B can be supplied to both ends of the pass-transistor circuit. In this case, this circuit can function as a logical product circuit or a logical sum circuit.

The logic circuit in accordance with the present invention outputs a logic signal and its inverted logic signal at the same time. Accordingly, it is suitable for applications of a driving circuit of the type which is composed of two BiCMOS amplifiers connected to form a flip-flop and which has a high speed, high load driving capacity. Therefore, a logic circuit at the following stage can be driven at a high speed without increasing the number of pass gate stages, by combination of this type diving circuit with the logic circuit in accordance with the present invention, so that the integrated circuit can operate at a high speed.

In the case of incorporating the logic circuit in accordance with the present invention into an integrated circuit, a logical signal which is generated in the pass-transistor circuit and amplified in the driving circuit is propagated to a logic circuit of the following stage without changing the low voltage amplitude. In the logic circuit of the following stage, pull-up PMOS transistors are respectively connected to input terminals for input signals supplied to gates of NMOS transistors constituting a pass-transistor circuit (an input signal B and its inverted signal), so that a high level of the gate input signal is pulled up to a high voltage supply potential, with the result that the channel resistance of the NMOS transistor is lowered in order to realize a high speed operation. The pass-transistor circuit essentially operates at a high speed and the voltage amplitude of the output signal is small. Accordingly, it is possible to achieve a high speed operation and a low power consumption of an integrated circuit.

According to a third aspect of the present invention, there is provided a first logic circuit comprising a first NMOS transistor having a source connected to a first input terminal, a second NMOS transistor having a source connected to a second input terminal, a third NMOS transistor having a source to said second input terminal and a fourth NMOS transistor having a source connected to said first input terminal, the gates of said first and third NMOS transistors being connected to a third input terminal and the gates of said second and fourth NMOS transistors being connected to a fourth input terminal, a first NPN bipolar transistor having a collector connected to a first power supply terminal, a first PMOS transistor having a drain connected to a base of said first bipolar transistor, a fifth NMOS transistor having a drain connected to an emitter of said first bipolar transistor and a source connected to a second power supply terminal, a second NPN bipolar transistor having a collector connected to said first power supply terminal, a second PMOS transistor having a drain connected to a base of said bipolar transistor and a source connected to said first power supply terminal and a sixth NMOS transistor having a source connected to said power supply terminal, the drains of said first and second NMOS transistors and said first PMOS transistor and the gate of said second PMOS transistor being connected to form a first output terminal, the drains of said third and fourth NMOS transistors and said second PMOS transistor and the gate of said first PMOS transistors being connected to form a second output terminal, the emitter of said first bipolar transistor constituting a third output terminal, and the emitter of said second bipolar transistor constituting a fourth output terminal.

According to a fourth aspect of the present invention, there is provided a second logic circuit comprising a first NMOS transistor having a source connected to a first input terminal, a second NMOS transistor having a source connected to a second input terminal, a third NMOS transistor having a source to said second input terminal and a fourth NMOS transistor having a source connected to said first input terminal, the gates of said first and third NMOS transistors being connected to a third input terminal and the gates of said second and fourth NMOS transistors being connected to a fourth input terminal, a first NPN bipolar transistor having a collector connected to a first power supply terminal, a first PMOS transistor having a drain connected to a base of said first bipolar transistor and a source connected to said first power supply terminal, a second NPN bipolar transistor having a collector connected to an emitter of said first bipolar transistor and an emitter connected to a second power supply terminal, a fifth NMOS transistor having a drain connected to the emitter to said first bipolar transistor and a source connected to a base of said second NPN bipolar transistor, the source of said fifth NMOS transistor being connected through a first resistor to said second power supply terminal, a third NPN bipolar transistor having a collector connected to the first power supply terminal, a second PMOS transistor having a drain connected to a base of said third bipolar transistor and a source connected to said first power supply terminal, a fourth NPN bipolar transistor having a collector connected to an emitter of said third bipolar transistor and an emitter connected to said second power supply terminal and a sixth NMOS transistor having a drain connected to the emitter to said third bipolar transistor and a source connected to a base of said fourth bipolar transistor, the source of said sixth NMOS transistor being connected through a second resistor to said second power supply terminal, the base of said first bipolar transistor being connected to the gate of said sixth NMOS transistor, and the base of said third bipolar transistor being connected to the gate of said fifth NMOS transistor, the drains of said first and second NMOS transistors and said first PMOS transistor and the gate of said second PMOS transistor being connected to form a first output terminal, the drains of said third and fourth NMOS transistors and said second PMOS transistor and the gate of said first PMOS transistors being connected to form a second output terminal, the emitter of said first bipolar transistor constituting a third output terminals and the emitter of said second bipolar transistor constituting a fourth output terminal.

According to a fifth aspect of the present invention, there is provided a third logic circuit comprising a first NMOS transistor having a source connected to a first input terminal, a second NMOS transistor having a source connected to a third input terminal, a third NMOS transistor having a source to a second input terminal and a fourth NMOS transistor having a source connected to a fourth input terminal, the gates of said first and third NMOS transistors being connected to said third input terminal and the gates of said second and fourth NMOS transistors being connected to said fourth input terminal, a first NPN bipolar transistor having a collector connected to a first power supply terminal, a first PMOS transistor having a drain connected to a base of said first bipolar transistor and a source connected to said first power supply terminal, a fifth NMOS transistor having a drain connected to an emitter of said first bipolar transistor and a source connected to said second power supply terminal, a second NPN bipolar transistor having a collector connected to said first power supply terminal, a second PMOS transistor having a drain connected to a base of said second bipolar transistor and a source connected to said first power supply terminal and a sixth NMOS transistor having a drain connected to the emitter of said second bipolar transistor and a source connected to said second power supply terminal, the drains of said first and second NMOS transistors and said first PMOS transistor and the gate of said second PMOS transistor being connected to form a first output terminal, the drains of said third and fourth NMOS transistors and said second PMOS transistor and the gate of said first PMOS transistors being connected to form a second output terminal, the emitter of said first bipolar transistor constitutes a third output terminal, and the emitter of said second bipolar transistor constituting a fourth output terminal.

According to a sixth aspect of the present invention, there is provided a fourth logic circuit comprising a first NMOS transistor having a source connected to a first input terminal, a second NMOS transistor having a source connected to a third input terminal, a third NMOS transistor having a source to a second input terminal and a fourth NMOS transistor having a source connected to said fourth input terminal, the gates of said first and third NMOS transistors being connected to said third input terminal and the gates of said second and fourth NMOS transistors being connected to said fourth input terminal, first NPN bipolar transistor having a collector connected to a first power supply terminal, a first PMOS transistor having a drain connected to a base of said first bipolar transistor and a source connected to said first power supply terminal, a second NPN bipolar transistor having a collector connected to an emitter of said first bipolar transistor and an emitter connected to said second power supply terminal, a fifth NMOS transistor having a drain connected to the emitter to said first bipolar transistor and a source connected to the base of said second NPN bipolar transistor, the source of said fifth NMOS transistor being connected through a first resistor to said second power supply terminal, a third NPN bipolar transistor having a collector connected to the first power supply terminal, a second PMOS transistor having a drain connected to the base of said third bipolar transistor and a source connected to said first power supply terminal, a fourth NPN bipolar transistor having a collector connected to an emitter of said third bipolar transistor and an emitter connected to said second power supply terminal, a sixth NMOS transistor having a drain connected to the emitter to said third bipolar transistor and a source connected to a base of said fourth bipolar transistor, the source of said sixth NMOS transistor being connected through a second resistor to said second power supply terminal, the base of said first bipolar transistor being connected to the gate of said sixth NMOS transistor, and the base of said third bipolar transistor being connected to the gate of said fifth NMOS transistor, the drains of said first and second NMOS transistors and said first PMOS transistor and the gate of said second PMOS transistor being connected to form a first output terminal, the drains of said third and fourth NMOS transistors and said second PMOS transistor and the gate of said first PMOS transistors being connected to form a second output terminal, the emitter of said first bipolar transistor constituting a third output terminal, and the emitter of said third bipolar transistor constituting a fourth output terminal.

In the first logic circuit, in the case of using one pair of complementary input signals (A and $\overline{A}$) having an inverted value to each other and another pair of complementary input signals (B and $\overline{B}$) also having an inverted value to each other, the NMOS transistors are connected in such a way that the signal $\overline{A}$ is outputted when the signal B is 1 while the signal A is outputted when the signal B is 0 so as to form a pass logic EX-OR circuit. Further, the NMOS transistors are connected in such a way that the signal A is outputted when the signal B is 1 while the signal $\overline{A}$ is outputted when the signal B is 0 so as to form a pass logic EX-NOR circuit. A pull-up PMOS transistor is connected to an output terminal so as to pull up a low amplitude voltage of the previous stage to the power supply voltage. This output signal is used to control the other transistor gates. The output signal of the EX-OR circuit and the EX-NOR circuit is amplified by a BiNMOS type circuit and used as another output signal. This output has an amplitude lower than that of the power supply voltage by the built-in voltage. Furthermore, this circuit is driven by a bipolar transistor. For this purpose, a circuit having a large driving capacity and a large load is used to be driven. This circuit can operate at a high speed by selecting an output terminal according to the amount of the load.

In the second logic circuit, in the case of using one pair of complementary input signals (A, $\overline{A}$) having an inverted value to each other and another pair of complementary input signals (B, $\overline{B}$) also having an inverted value to each other, the NMOS transistors are connected in such a way that the signal $\overline{A}$ is outputted when the signal B is 1 while the signal A is outputted when the signal B is 0 so as to form a pass logic EX-OR circuit. Further, the NMOS transistors are connected in such a way that the signal A is outputted when the signal B is 1 while the signal $\overline{A}$ is outputted when the signal B is 0 so as to form a pass logic EX-NOR circuit. A pull-up PMOS transistor is connected to an output terminal so as to pull up a low amplitude voltage of the previous stage to the power supply voltage. This output signal is used to control the other transistor gates. The output signal of the EX-OR circuit and the EX-NOR circuit is amplified by a BiCMOS type circuit and used as another output signal. This output has an amplitude lower than that of the power supply voltage by the built-in voltage. Furthermore, this circuit is driven by a bipolar transistor. For this purpose, a circuit having a large driving capacity and a large load is used to be driven. The pull-down speed is high because it is also executed by a bipolar transistor. This circuit can operate at a high speed by selecting an output terminal according to the amount of the load.

In the third logic circuit, in the case of using one pair of complementary input signals (A, $\overline{A}$) having an inverted value to each other and another pair of complementary input signals (B, $\overline{B}$) also having an inverted value to each other, the NMOS transistors are connected in such a way that the signal A is outputted when the signal B is 1 while the signal B is outputted when the signal B is 0 so as to form a pass logic AND circuit. Further, the NMOS transistors are connected in such a way that the signal $\overline{A}$ is outputted when the signal B is 1 while the signal a $\overline{B}$ is outputted when the signal B is 0 so as to form a pass logic NAND circuit. Pull-up PMOS transistors are connected to the input terminals to the gates of the NMOS transistors so as to pull up a low amplitude voltage of the previous stage to the power supply voltage. The output signal of the AND circuit and the NAND circuit is amplified by a BiNMOS type circuit and supplied to a logic circuit of the following stage. A signal passing through the critical path of the logic circuit has a high-voltage side of the logic amplitude which is lower by the Vt of the MOS transistors and after passing through the amplifier circuit, it is also lower by the built-in voltage as described above. Namely, since the voltage amplitude is always controlled to be low, the circuit can operate at a high speed with a low power consumption. Similarly, in the case of using one pair of input signals (A, $\overline{A}$) having an inverted value to each other and another pair of input signals (B, $\overline{B}$) also having an inverted value to each other, the NMOS transistors are connected in such a way that the signal B is outputted when the signal B is 1 while the signal $\overline{A}$ is outputted when the signal B is 0 so as to form a pass logic OR circuit. Further, the NMOS transistors are connected in such a way that the signal signal $\overline{B}$ is outputted when the signal B is 1 while the signal A is outputted when the signal B is 0 so as to form a pass logic NOR circuit.

In the fourth logic circuit, in the case of using one pair of complementary input signals (A, $\overline{A}$) having an inverted value to each other and another pair of complementary input signals (B, $\overline{B}$) also having an inverted value to each other, the NMOS transistors are connected in such a way that the signal A is outputted when the signal B is 1 while the signal B is outputted when the signal B is 0 so as to form a pass logic AND circuit. Further, the NMOS transistors are connected in such a way that the signal $\overline{A}$ is outputted when the signal B is 1 while the signal $\overline{B}$ is outputted when the signal B is 0 so as to form a pass logic NAND circuit. Pull-up PMOS transistors are connected to the input terminals to the gates of the NMOS transistors so as to pull up a low amplitude voltage of the previous stage to the power supply voltage. The output signal of the AND circuit and the NAND circuit is amplified by a BiCMOS type circuit and supplied to a logic circuit of the following stage. A signal passing through the critical path of the logic circuit has a high-voltage side of the logic amplitude which is lower by the Vt of the MOS transistors and after passing through the amplifier circuit, it is also lower by the built-in voltage as described above. Namely, since the voltage amplitude is always controlled to be low, the circuit can operate at a high speed with a low power consumption. Similarly, in the case of using one pair of input signals (A, $\overline{A}$) having an inverted value to each other and another pair of input signals (B, $\overline{B}$) also having an inverted value to each other, the NMOS transistors are connected in such a way that the signal B is outputted when the signal B is 1 while the signal $\overline{A}$ is outputted when the signal B is 0 so as to form a pass logic OR circuit. Further, the NMOS transistors are connected in such a way that the signal signal $\overline{B}$ is outputted when the signal B is 1 while the signal A is outputted when the signal B is 0 so as to form a pass logic NOR circuit.

The above and other objects, features and advantages of the present invention will be apparent from the following description of preferred embodiments of the invention with reference to the accompanying drawings.

Brief Description of the Drawings

Figure 1A is a circuit diagram of a first embodiment of the logic circuit in accordance with the present invention;

Figure 1B is a truth table of the circuit shown in Figure 1A;

Figure 2A is a circuit diagram of a second embodiment of the logic circuit in accordance with the present invention;

Figure 2B is a truth table of the circuit shown in Figure 2A;

Figure 3A is a circuit diagram of a third embodiment of the logic circuit in accordance with the present invention;

Figure 3B is a truth table of the circuit shown in Figure 3A;

Figure 4 is a circuit diagram of a fourth embodiment of the logic circuit in accordance with the present invention;

Figure 5 is a circuit diagram of a fifth embodiment of the logic circuit in accordance with the present invention;

Figure 6 is a circuit diagram of a sixth embodiment of the logic circuit in accordance with the present invention; and

Figure 7 is a circuit diagram of a seventh embodiment of the logic circuit in accordance with the present invention.

Description of the Preferred embodiments

Now, preferred embodiments of the present invention will be explained.

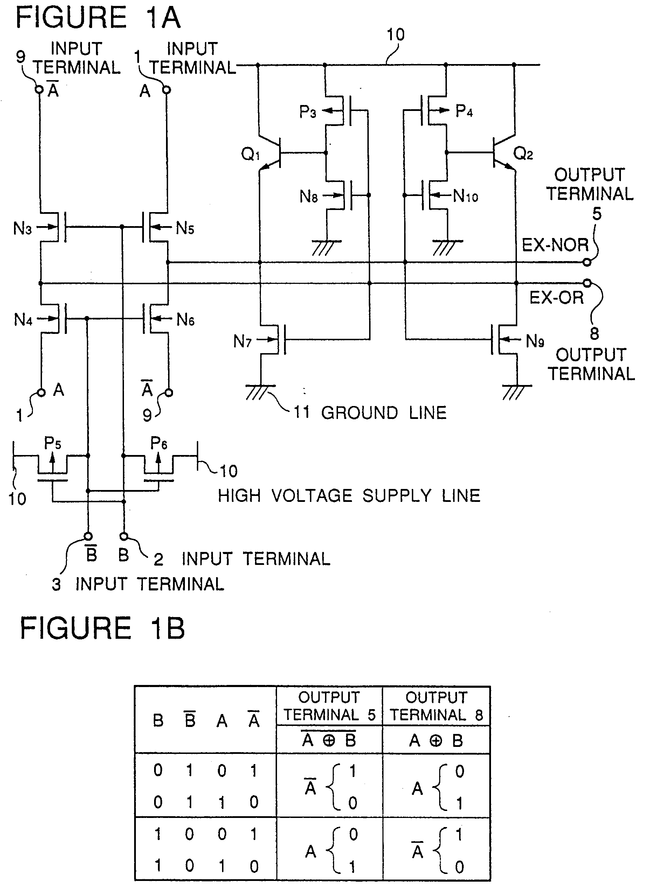

Referring to Figure 1A, there is shown a circuit diagram of a first embodiment in accordance with the present invention. The shown circuit outputs an exclusive logical sum of an input signal A and an input signal B and its negation to output terminals 8 and 5, respectively. Referring to Figure 1A, the circuit of this embodiment comprises a logic circuit part composed of four NMOS transistors $N_3$ to $N_6$, a driving circuit part formed by a combination of two BiCMOS amplifier circuits each composed of an NPN bipolar transistor and NMOS transistors, and a pull-up circuit part including two PMOS transistors $P_5$ and $P_6$.

In the logic circuit part, two NMOS transistors $N_3$ and $N_4$ are connected in series between input terminals 9 and 1, and a connection node between the NMOS transistors $N_3$ and $N_4$ is connected to the output terminal 8. Further, two NMOS transistors $N_5$ and $N_6$ are connected in series between the input terminal 1 and 9 and a connection node between the NMOS transistors $N_5$ and $N_6$ is connected to the output terminal 5. The input terminal 1 receives an input signal A and the input terminal 9 receives an inverted signal of the input signal A. An input signal B is supplied to gates of the NMOS transistors $N_3$ and $N_5$, and an inverted signal of the input signal B is supplied to gates of the NMOS transistors $N_4$ and $N_6$.

Now, in Figure 1A, if the input signal B is "0", the NMOS transistors $N_3$ and $N_5$ are in an OFF condition and the NMOS transistors $N_4$ and $N_6$ are in an ON condition, so that the inverted signal of the input signal A is outputted to the output terminal 5 and the input signal A is outputted to the output terminal 8. On the other hand, if the input signal B is "1", the NMOS transistors $N_3$ and $N_5$ are in an ON condition and the NMOS transistors $N_4$ and $N_6$ are in an OFF condition, so that the input signal A is outputted to the output terminal 5 and the inverted signal of the input signal A is outputted to the output terminal 8. The above logic states can be expressed by a truth table shown in Figure 1B. It would be understood that, in this embodiment, an exclusive logical sum and its negation can be obtained at the same time by means of a circuit having a simple structure. Further, the output signals EX-OR and EX-NOR have a high level which is lower by a threshold voltage of the NMOS transistors, and therefore, a logical amplitude of !he output signals is small. This is advantageous in realizing a logic circuit which operates at a high speed and with a low power consumption. Furthermore, the logic circuit part of this embodiment is different from the conventional logic circuit in that the input signal A is connected only to the source electrode capacitance of the NMOS transistors $N_4$ and $N_5$ and not to the gate electrodes of the other NMOS transistors . Thus, the logic circuit part of this embodiment has a reduced load capacitance with respect to the input signal A, which is advantageous for a high speed operation.

In the driving circuit part, the two BiCMOS amplifier circuits are connected to each other in such a way that an output of each one circuit is supplied to an input of the other circuit as one of input signals for the other circuit. An input terminal of one amplifier circuit receives the exclusive logical sum from the logical circuit part, while an input terminal of the other amplifier circuit receives the negation of the exclusive logical sum from the logical circuit part. In one of the BiCMOS amplifier circuits constituting this driving circuit, an NPN bipolar transistor $Q_1$ and an NMOS transistor $N_6$ are connected in series between a high level voltage supply line 10 and a ground line 11, and a connection node between the NPN bipolar transistor $Q_1$ and the NMOS transistor $N_6$ constitutes an output terminal. A base electrode of the NPN bipolar transistor $Q_1$ is connected to an intermediate connection node of a series circuit of a PMOS transistor $P_3$ and an NMOS transistor $N_8$ connected in series between the high level voltage supply line 10 and the ground line 11. In addition, gate electrodes of the PMOS transistor $P_3$ and the NMOS transistors $N_8$ and $N_7$ are connected to the input terminal of this amplifier circuit. The other BiCMOS amplifier circuit has the same structure.

In this driving circuit, the NPN bipolar transistors are used in an output stage to improve the driving capacity. Further, the output signal of one BiCMOS amplifier circuit is fed back to the input terminal of the other BiCMOS amplifier circuit, and the output signal of the other BiCMOS amplifier is supplied to the input terminal of the one amplifier circuit, so that the two input signals are amplified in a complimentary way. A MOS transistor having a small gate length and a small input capacitance is used in order to drive a bipolar transistor, which reduces a load capacitance to be driven by the circuit of the preceding stage (the above mentioned logical circuit part in this embodiment). Further, the high level of the output signal is lower than the high voltage supply potential by a built-in voltage of the NPN bipolar transistor. For example, if the high voltage supply potential is 3.3V, the high level of the output signal is about 2.7V, and the signal amplitude is small. This is effective to operate the circuit at a high speed with a low power consumption. As a result, the input signal is amplified at a high speed. If a pair of complementary signals having a rising and a falling well in synchronism are supplied to this driving circuit part as input signals, this driving circuit stably operates and shows the above mentioned characteristics. Accordingly, this driving circuit is suitable for applications to the combination with the logic circuit part of this embodiment.

Then, pull-up PMOS transistors $P_5$ and $P_6$ are connected to the input terminals 2 and 3 of the logic circuit part of the present embodiment, respectively, in order to elevate the level of the input signal B and its inverted signal. The PMOS transistor $P_5$ has a source electrode connected to the high voltage supply terminal 10, a drain electrode connected to the input terminal 3 and a gate connected to receive the input signal B. Similarly, the PMOS transistor $P_6$ has a source electrode connected to the high voltage supply terminal 10, a drain electrode connected to the input terminal 2 and a gate connected to receive the inverted signal of the input signal B. If the high level of the input signal B and its inverted signal is low, the channel resistance of the NMOS transistors $N_3$ to $N_6$ controlled by these signals becomes high, so that the signal propagation speed becomes low. Then, the high level of the input signal B and its inverted signal is pulled up to the high voltage supply level by means of the pull-up PMOS transistors $P_5$ and $P_6$ in order to maintain the high speed performance.

In general, in order to drive a MOS transistor at a high speed, a gate input signal is preferably a full amplitude signal which swings fully between the high voltage supply potential and the ground potential. However, in the logic circuit part and the driving logic circuit part of the present embodiment, the amplitude of the output signal is restricted to be small. On the contrary, if the gate input signal level of the NMOS transistors in the logic circuit part is pulled up as mentioned above, the logic circuit in accordance with the present invention, which is cascade-connected in an integrated circuit, can fully exhibit the characteristics of the high speed operation and the low power consumption.

In this case, in the conventional logic circuit, since the input signal A is further supplied to the gate electrodes of the PMOS transistor $P_2$ and the NMOS transistor $N_2$, it is necessary to provide pull-up transistors not only at the input terminal 2 and 3 of the input signal B and its inverted signal and also at the input terminal 1 of the input signal A in order to increase the level of the input signal A. Therefore, the number of transistors becomes large. On the contrary, in the present embodiment, the input signal A and its inverted signal are not connected to a gate of anyone of the NMOS transistors $N_3$ to $N_6$ in the logic circuit part. Accordingly, it is not necessary to provide pull-up PMOS transistors on these signal lines.

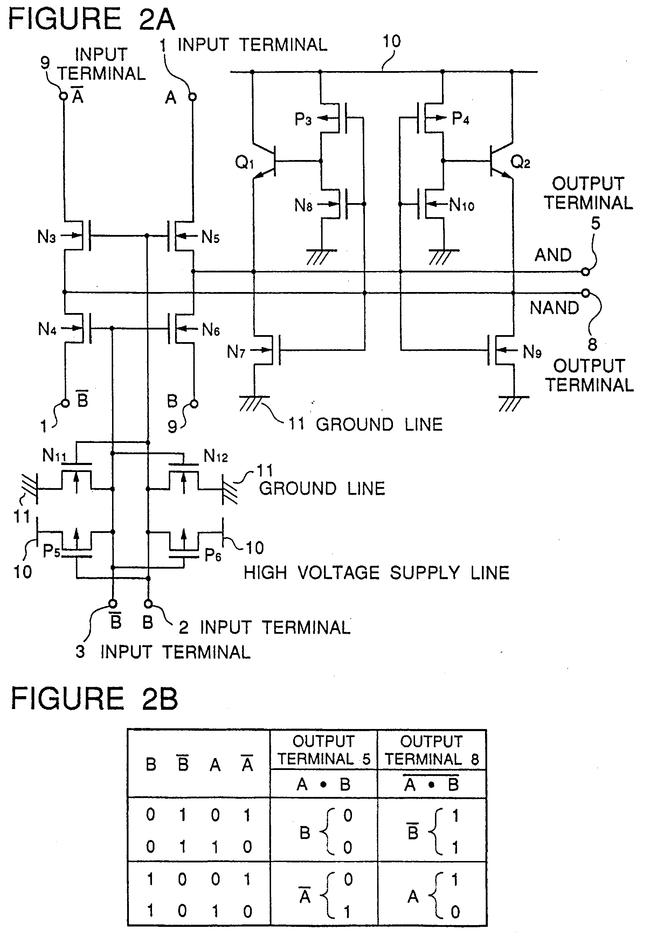

In the first embodiment mentioned above, it was described that the circuit executes the exclusive logical sum operation and the not-exclusive-logical-sum (exclusive-NOR) operation, by using the combination of the signals supplied to the input terminal 10 and 9 as a pair of the input signal A and its inverted signal. However, as a second embodiment shown in Figure 2A, it is also possible to execute a logical product (AND) operation and a not-logical-product (NAND) operation, by supplying a pair of signals consisting of input signals A and B and a pair of signals consisting of the inverted signals of the input signals A and B.

Figure 2A is a circuit diagram of a second embodiment of the logic circuit in accordance with the present invention. The logic circuit shown in this figure outputs a logical product of the input signals A and B to the output terminals 5, and also outputs its inverted logical product to the output terminal 8. Referring to Figure 2A, the logic circuit part of this embodiment comprises two NMOS transistors $N_3$ and $N_4$ connected in series between input terminals 9 and 3, a connection node between the NMOS transistors $N_3$ and $N_4$ being connected to an output terminal 8. The logic circuit part also comprises two NMOS transistors $N_5$ and $N_6$ connected in series between input terminals 1 and 2, a connection node between the NMOS transistors $N_5$ and $N_6$ being connected to an output terminal 5. The input terminal 1 receives the input signal A, while the input terminal 9 receives an inverted signal of the input signal A. The gates of the NMOS transistor $N_3$ and $N_5$ receive the input signal B, while the gates of the NMOS transistor $N_4$ and $N_6$ receives an inverted signal of the input signal B. In Figure 2A, when the input signal B is "0", the NMOS transistors $N_3$ and $N_5$ are in an OFF condition and the NMOS transistors $N_4$ and $N_6$ are in an ON condition. Thus, the input signal B is outputted to the output terminal 5 and the inverted signal of the input signal B is outputted to the output terminal 8. On the other hand, when the input signal B is "1", the NMOS transistors $N_3$ and

$N_5$ are in an ON condition and the NMOS transistors $N_4$ and $N_6$ are in an OFF condition. Thus, the input signal A is outputted to the output terminal 5 and the inverted signal of the input signal A is outputted to the output terminal 8. The logical states can be expressed by a truth table shown in Figure 2B. It will be understood that the logical product operation and the not-logical-product operation are executed at the same time in this logic circuit part.

Then, in this embodiment, in addition to pull-up PMOS transistors, pull-down NMOS transistors are connected to the input terminals 2 and 3 receiving the input signal B and its inverted signal, respectively, in order to increase the speed of the pull-down. A pull-down NMOS transistor $N_{11}$ has a source electrode connected to the ground line 11, a drain electrode connected to the input terminal 3 and a gate connected to receive the input signal B. Similarly, the NMOS transistor $N_{12}$ has a source electrode connected to the ground line 11, a drain electrode connected to the input terminal 2 and a gate connected to receive the inverted signal of the input signal B. Unlike the conventional logic circuit, the logic circuit of this embodiment does not have to comprise pull-up and pull-down NMOS transistors at the input terminals of the input signal A and its inverted signal, and therefore, this logic circuit includes a smaller number of transistors, so that this logic circuit can operate at a high speed in comparison with the conventional logic circuit. In addition, if the driving circuit part shown in Figure 1A is connected to the logic circuit as shown in Figure 2B, it is possible to sufficiently utilize advantage of the high-speed driving performance of this driving circuit, similarly to the first embodiment.

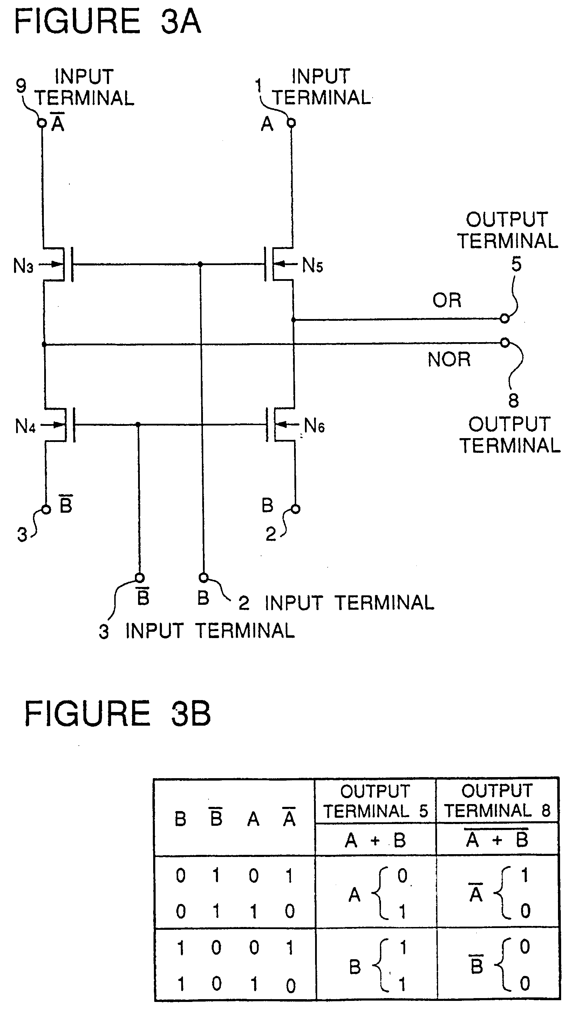

In addition, in the circuit shown in Figure 2A, this logic circuit part can operate as a logical sum circuit and a not-logical-sum circuit if the polarities of the input signal B and its inverted signal supplied to the gates of the four NMOS transistors of the logic are made to be opposite to those of the second embodiment, like a third embodiment shown in Figure 3A.

Figure 3A is a circuit diagram of the circuit of the third embodiment of the circuit in accordance with the present invention. The logic circuit part shown in this figure outputs a logical sum of the input signals A and B to an output terminal 5, and also outputs a not-logical-sum of the input signals A and B to an output terminal 8. Referring to Figure 3A, the logic circuit part of this embodiment is different from the logic circuit of the second embodiment shown in Figure 2A in connection to the gate inputs of the four NOMS transistors $N_3$ to $N_6$. In this embodiment, the gates of the NMOS transistors $N_3$ and $N_5$ receive the inverted signal of the input signal B, while the gates of the NMOS transistors $N_4$ and $N_6$ receive the input signal B. Now, in Figure 3A, if the input signal B is "0", the NMOS transistors $N_4$ and $N_6$ are in an OFF condition and the NMOS transistors $N_3$ and $N_5$ are in an ON condition, so that the input signal A is outputted to the output terminal 5 and the inverted signal of the input signal A is outputted to the output terminal 8. On the other hand, if the input signal B is "1", the NMOS transistors $N_4$ and $N_6$ are in an ON condition and the NMOS transistors $N_3$ and $N_5$ are in an OFF condition, so that the input signal B is outputted to the output terminal 5 and the inverted signal of the input signal B is outputted to the output terminal 8. The logical states can be expressed by a truth table shown in Figure 3B. It will be understood that the logical sum (OR) operation and the not-logical-sun, (NOR) operation are executed at the same time in this logic circuit.

In this embodiment, it is also possible to combine the logic circuit part with the driving circuit part shown in Figure 1A so as to take advantage of its high-speed load driving capacity. Further, if pull-up PMOS transistors and pull-down NMOS transistors are connected only to the input terminals 2 and 3 in the logic circuit part, this circuit can operate at a higher speed with a small number of transistors in comparison with the conventional logic circuit.

As explained above, the logic circuit in accordance with the present invention comprises two pass-transistor circuits so configured that the polarity of an input signal applied to one of the pass-transistor circuits is in an inverted relation to the polarity of an input signal applied to the other pass-transistor circuit, so that an logic output and its inverted logic output having a rising and a falling well in synchronism with each other are obtained at the same time. Accordingly, according to the present invention, it is possible to use a driving circuit of the type which can operate at a high speed with a high load driving capacity, and which can be constituted of BiCMOS amplifier circuits connected in the form of a flipflop so as to complementarily amplify a pair of input signals having an opposite polarity to each other. In addition, since the load of the input signal is reduced in the logic circuit in accordance with the present invention, the structure of the pull-up and pull-down circuits of the input signals is correspondingly simplified. In the case that the logic circuits of the present invention are used to be cascade-connected on a large scale integrated circuit, the logic circuits of the present invention is very effective in increasing the operation speed of the integrated circuit, in lowering the power consumption and in increasing the integration density.

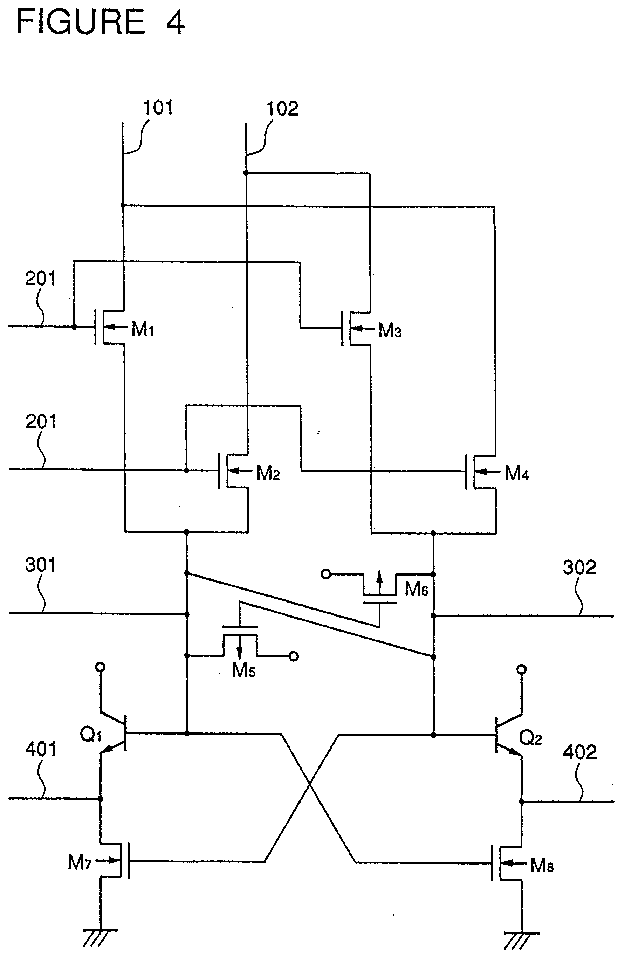

Figure 4 is a block diagram illustrating a fourth embodiment of the present invention. The circuit

comprises bipolar transistors $Q_1$ and $Q_2$, PMOS transistors $M_5$ and $M_6$ and NMOS transistors $M_1$, $M_2$, $M_3$, $M_4$, $M_7$ and $M_8$. It also comprises input terminals 101, 102 and 201, 202 and output terminals 301, 302 and 401, 402. The input terminals 101 and 102 receive a pair of complementary signals A and $\overline{A}$ having an inverted value to each other, respectively, and similarly, the input terminals 201 and 202 receive a pair of complementary signals B and $\overline{B}$, respectively. When the signal B is "1", the NMOS transistors $M_1$ and $M_3$ are turned on and the transistors $M_2$ and $M_4$ are turned off. As the result, the values of the signals A and $\overline{A}$ are outputted to the output terminals 301 and 302, respectively. On the other hand, when the signal B is "0", the transistors $M_2$ and $M_4$ are turned on and the transistors $M_1$ and $M_3$ are turned off so that the values of the signals $\overline{A}$ and A are outputted to the output terminal 302 and 301, respectively. Thus, an EX-NOR output and an EX-OR output are obtained at the output terminals 302 and 301, respectively. Namely, the EX-OR and EX-NOR output signals are obtained only by passing through the NMOS transistors so that this circuit can operate at a high speed. The high voltage level of the signal which has passed through the NMOS transistors is lower than the power supply voltage by a threshold voltage Vt of the MOS transistors. The signals at the output terminal 301 and 302 are amplified to the power supply voltage by the PMOS transistors $M_5$ and $M_6$. The signals inputted from the input terminals 201 and 202 control the gates of the MOS transistors. If the high level of these signal is low, the NMOS transistors controlled by the signal have a high channel resistance so that the signal propagation speed is low. Then, the signals of the output terminals 301 and 302 are supplied to the input terminals 201 and 202. Further, the signals at the output terminals 301 and 302 are amplified by a BiNMOS type circuit in order to drive a large load. The output terminals 401 and 402 are used to drive the source of the transfer gate and the large capacitance load of the logic circuit of the following stage to be driven.

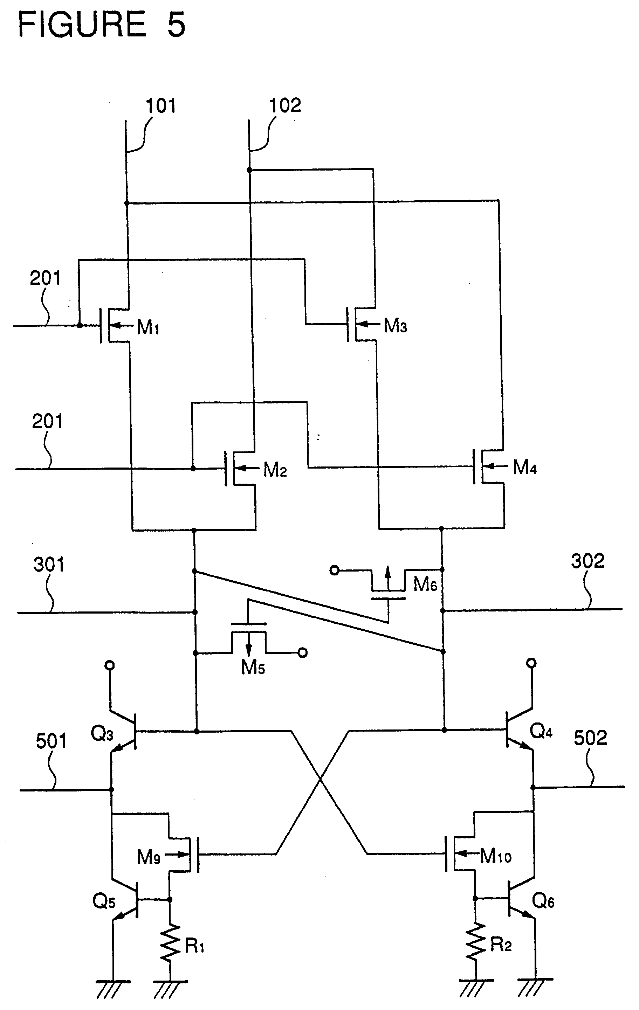

Figure 5 is a block diagram illustrating a fifth embodiment of the present invention. The circuit comprises bipolar transistors $Q_3$, $Q_4$, $Q_5$ and $Q_6$, PMOS transistors $M_5$ and $M_6$, NMOS transistors $M_1$, $M_2$, $M_3$, $M_4$, $M_9$ and $M_{10}$ and resistors $R_1$ and $R_2$. It also comprises input terminals 101, 102 and 201, 202 and output terminals 301, 302 and 501, 502. The input terminals 101 and 102 receives a pair of complementary signals A and $\overline{A}$ having an inverted value to each other, respectively, and similarly, the input terminals 201 and 202 receive a pair of complementary signals B and $\overline{B}$, respectively. When the signal B is "1", the NMOS transistors $M_1$ and $M_3$ are turned on and the transistors $M_2$ and

$M_4$ are turned off. Therefore, the values of the signals A and $\overline{A}$ are outputted to the output terminals 301 and 302, respectively. On the other hand, when the signal B is "0", the transistors $M_2$ and $M_4$ are turned on and the transistors $M_1$ and $M_3$ are turned off so that the values of the signals $\overline{A}$ and A are outputted to the output terminals 302 and 301, respectively. Thus, an EX-OR output and an EX-NOR output are obtained at the output terminals 302 and 301, respectively. Namely, the EX-OR and EX-NOR output signals are obtained only by passing through the NMOS transistors so that this circuit can operate at a high speed. The high voltage level of the signal which has passed through the NMOS transistors is lower than the power supply voltage by a threshold voltage Vt of the MOS transistors. The signals at the output terminals 301 and 302 are amplified to the power supply voltage by the PMOS transistors $M_5$ and $M_6$. The signals inputted from the input terminals 201 and 202 control the gates of the MOS transistors. If the high level of these signal is low, the NMOS transistors controlled by the signals have a high channel resistance so that the signal propagation speed is low. Then, the signals of the output terminals 301 and 302 are supplied to the input terminals 201 and 202. Further, the signals at the output terminals 301 and 302 are amplified by a BiCMOS type circuit in order to drive a large load. The output terminals 401 and 402 are used to drive the source of the transfer gate and the large capacitance load of the logic circuit of the following stage to be driven.

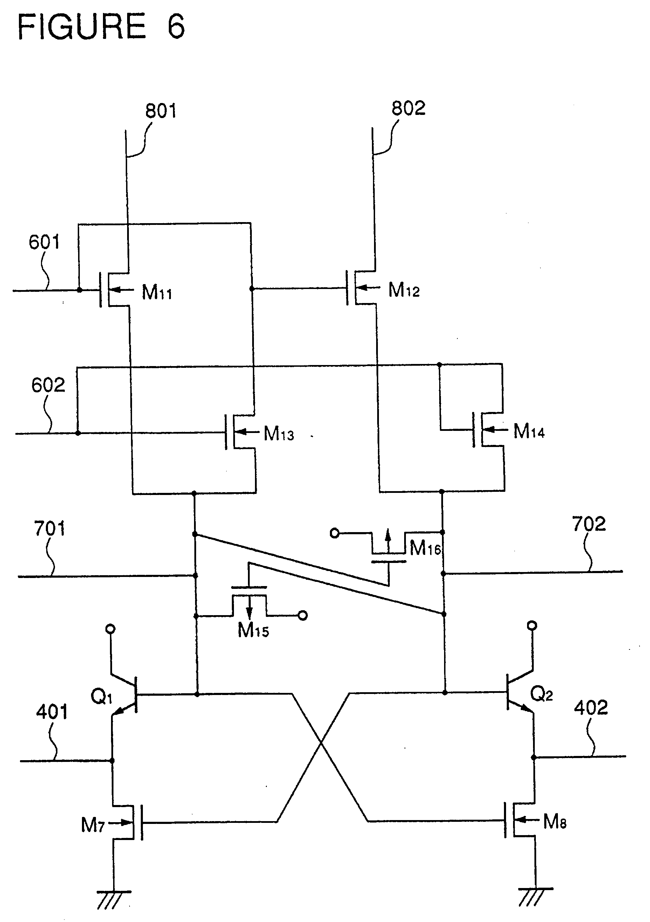

Figure 6 is a block diagram illustrating a sixth embodiment of the present invention. The circuit comprises bipolar transistors $Q_1$ and $Q_2$, PMOS transistors $M_{15}$ and $M_{16}$ and NMOS transistors $M_{11}$, $M_{12}$, $M_{13}$, $M_{14}$, $M_7$ and $M_8$. It also comprises input terminals 801, 802 and 601, 602 and output terminals 701, 702 and 401, 402. The input terminals 801 and 802 receive a pair of complementary signals A and $\overline{A}$ having an inverted value to each other, respectively, and similarly, the input terminals 601 and 602 receive a pair of complementary signals B and $\overline{B}$, respectively. When the signal B is "1", the NMOS transistors $M_{11}$ and $M_{12}$ are turned on and the transistors $M_{13}$ and $M_{14}$ are turned off. Therefore, the values of the signals A and $\overline{A}$ are outputted to the outputs terminal 701 and 702, respectively. On the other hand, when the signal B is "0", the transistors $M_{13}$ and $M_{14}$ are turned on and the transistors $M_{11}$ and $M_{12}$ are turned off so that the values of the signals B and $\overline{B}$ are outputted to the output terminals 701 and 702, respectively. Thus, an AND output and a NAND output are obtained at the output terminals 701 and 702, respectively. Namely, the AND and NAND output signals are obtained only by passing through the NMOS transistors so that this circuit can operate at a high speed. The high voltage level of the signal which has passed through the NMOS transistors is lower than the power supply voltage by a threshold voltage Vt of the MOS transistors. The drains of the PMOS transistors are connected to the output terminals 701 and 702 and the sources are connected to the power supply voltage terminal so that the high voltage level of the input signal is pulled up to the power supply voltage level. The signals inputted from the input terminals 601 and 602 control the gates of the MOS transistors. If the high level of these signals is low, the NMOS transistors controlled by the signals have a high channel resistance so that the signal propagation speed is low. Then, the signals of the output terminals 701 and 702 are supplied to the input terminals 601 and 602. Further, the signals at the output terminal 701 and 702 are amplified by a BiCMOS type circuit in order to drive a large load. The output terminals 401 and 402 are used to drive the source of the transfer gate and the large capacitance load of the logic circuit of the following stage to be driven.

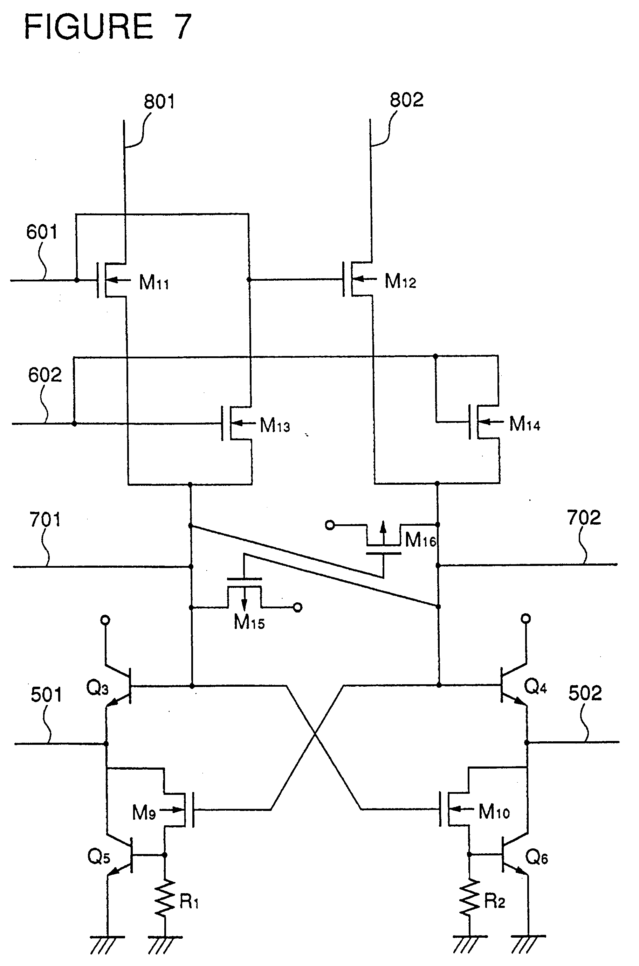

Figure 7 is a block diagram illustrating a seventh embodiment of the present invention. The circuit comprises bipolar transistors $Q_3$, $Q_4$, $Q_5$ and $Q_6$, PMOS transistors $M_{15}$ and $M_{16}$, NMOS transistors $M_{11}$, $M_{12}$, $M_{13}$, $M_{14}$, $M_9$ and $M_{10}$ and resistors $R_1$ and $R_2$. It also comprises input terminals 801, 802 and 601, 602 and output terminals 701, 702 and 501, 502. The input terminals 801 and 802 receive a pair of complementary signals A and $\overline{A}$ having an inverted value to each other, respectively, and similarly, the input terminals 601 and 602 receive a pair of complementary signals B and $\overline{B}$, respectively. When the signal B is "1", the NMOS transistors $M_{11}$ and $M_{12}$ are turned on and the transistors $M_{13}$ and $M_{14}$ are turned off. Therefore, the values of the signals A and $\overline{A}$ are outputted to the outputs terminal 701 and 702, respectively. On the other hand, when the signal B is "0", the transistors $M_{13}$ and $M_{14}$ are turned on and the transistors $M_{11}$ and $M_{12}$ are turned off so that the values of the signals B and $\overline{B}$ are outputted to the output terminal 701 and 702, respectively. Thus, an AND output and a NAND output are obtained at the outputs terminal 701 and 702, respectively. Namely, the AND and NAND output signals are obtained only by passing through the NMOS transistors so that this circuit can operate at a high speed. The high voltage level of the signal which has passed through the NMOS transistors is lower than the power supply voltage by a threshold voltage Vt of the MOS transistors. The drains of the PMOS transistors are connected to the output terminals 701 and 702 and the sources are connected to the power supply voltage terminal so that the high voltage level of the input signal is pulled up to the power supply voltage level. The signals inputted from the input terminals 601 and 602 control the gates of the MOS transistors. If the high level of this signal is low, the NMOS transistor controlled by the signal has a high channel resistance so that the signal propagation speed is low. Then, the signals of the output terminals 701 and 702 are supplied to the input terminals 601 and 602. Further, the signals at the output terminal 701 and 702 are amplified by a BiCMOS circuit in order to drive a large load. The output terminals 401 and 402 are used to drive the source of the transfer gate and the large capacitance load of the logic circuit of the following stage to be driven.

As mentioned above, according to the fourth embodiment, two output signal levels of the pass logic EX-OR and EX-NOR circuits, that is, the CMOS level and the BiNMOS level are used. These levels are used properly and propagated to the logic circuit of the following stage so that the high-speed operation can be realized.

According to the fifth embodiment, two output signal levels of the pass logic EX-OR and EXNOR circuits, that is, die CMOS level and the BiCMOS level are used. These levels are used properly and propagated to the logic circuit of tee following stage so that the high-speed operation can be realized.

According to the sixth embodiment, two output signal levels of the pass logic AND, NAND, OR and NOR circuits, that is, the CMOS level and the BiNMOS level are used. These levels are used, properly and propagated to the logic circuit of the following stage so that the high-speed operation can be realized.

According to the seventh embodiment, two output signal levels of the pass logic AND, NAND, OR and NOR circuits, that is, the CMOS level and the BiCMOS level are used. These levels are used properly and propagated to the logic circuit of the following stage so that the high-speed operation can be realized.

The invention has thus been shown and described with reference to the specific embodiments. However, it should be noted that the present invention is in no way limited to the details of the illustrated structures but changes and modifications may be made within the scope of the appended claims.

## Claims

1. A logic circuit comprising at least one pass-transistor circuits composed of two transistors connected in series between a pair of input signal terminals, a pair of logic signals being supplied to opposite end of the pass-transistor circuit, and a connection node between the two transistors of the pass-transistor circuit constituting an output node for generating an output logic signal, and respective control electrodes of the two transistors of the pass-transistor circuit being connected to receive a pair of complementary logic signals so that conducting conditions of the two transistors are controlled by the pair of complementary logic signals, respectively.

2. A logic circuit receiving a first pair of complementary logic input signals and a second pair of complementary logic input signals and generating a pair of complementary logic output signals, the logic circuit comprising first and second pass-transistor circuits each composed of two transistors connected in series between a pair of input signal terminals, a connection node between said transistors of each of said pass-transistor circuits generating a corresponding one of said pair of complementary logic output signals, one of said pair of input signal terminals of said first pass-transistor circuits receiving a selected one of said first pair of complementary logic input signals, and the other of said pair of input signal terminals of said first pass-transistor circuits receiving one of said first and second pairs of complementary logic input signals excluding said selected one of said first pair of complementary logic input signals, one of said pair of input signal terminals of said second pass-transistor circuits receiving the other of said first pair of complementary logic input signals, and the other of said pair of input signal terminals of said second pass-transistor circuits receiving one of said first and second pairs of complementary logic input signals excluding the other of said first pair of complementary logic input signals, the transistors of one pass transistor circuit being combined with the transistors of the other pass transistor circuit, respectively, to form first and second transistor pairs, and respective control electrodes of the transistors of said first transistor pair and respective control electrodes of the transistors of said second transistor pair being applied with said second pair of complementary logic input signals, respectively, so that conducting conditions of the first and second transistor pairs are controlled by said second pair of complementary logic input signals, respectively.

3. A logic circuit receiving a first pair of complementary logic input signals and a second pair of complementary logic input signals and generating a pair of complementary logic output signals, the logic circuit comprising;

a first pass-transistor circuit constituted of first and second first N-channel MOS field effect transistors connected in series between first and second input terminals, said first input terminal being connected to receive a selected one of said first pair of complementary logic input signals, and said second input terminal being connected to receive one of said first and second pairs of complementary logic input signals excluding said selected one of said first pair of complementary logic input signals,

a second pass-transistor circuit constituted of third and fourth N-channel MOS field effect transistors connected in series between third and fourth input terminals, said third input terminal being connected to receive the other of said first pair of complementary logic input signals, and said fourth input terminal being connected to receive one of said first and second pairs of complementary logic input signals excluding the other of said first pair of complementary logic input signals,

one of said second pairs of complementary logic input signals being supplied to a gate electrode of said first N-channel MOS field effect transistor and a gate electrode of said third N-channel MOS field effect transistor, respectively, and;

the other of said second pairs of complementary logic input signals being supplied to a gate electrode of said second N-channel MOS field effect transistor and a gate electrode of said fourth N-channel MOS field effect transistor, respectively.

4. A logic circuit claimed in Claim 3 wherein said first N-channel MOS field effect transistor has a source electrode supplied with a non-inverted signal of said first pair of complementary input logic signals and said second N-channel MOS field effect transistor has a source electrode supplied with an inverted signal of said first pair of complementary input logic signals, and wherein said third N-channel MOS field effect transistor has a source electrode supplied with said inverted signal of said first pair of complementary input logic signals, and said fourth N-channel MOS field effect transistor has a source electrode supplied with said non-inverted signal of said first pair of complementary input logic signals.

5. A logic circuit claimed in Claim 3 wherein said first N-channel MOS field effect transistor has a source electrode supplied with a non-inverted signal of said first pair of complementary input logic signals and said second N-channel MOS field effect transistor having a source electrode supplied with a non-inverted signal of said second pair of complementary input logic signals, and said third N-channel MOS field effect transistor has a source electrode supplied with an inverted signal of said first pair of complementary input logic signals, and said fourth N-channel MOS field effect transistor has a source electrode supplied with an inverted signal of said second pair of complementary input logic signals.

6. A logic circuit claimed in Claim 1 further including a driving circuit constituted of two BiCMOS-amplifier circuits connected in such a way that an output of each of said amplifier circuits is supplied as one of inputs to the other of said amplifier circuits, so that an output of said first pass-transistor circuit and an output of said second pass-transistor circuit, are amplified and then outputted.

7. A logic circuit claimed in any one of Claims 3 to 6, further including a driving circuit constituted of two amplifier circuits connected in such a way that an output of each of said amplifier circuits is supplied as one of inputs to the other of said amplifier circuits, each of said amplifier circuits having an output bipolar transistor and a MOS field effect transistor connected in series, a base potential of said output bipolar transistor being driven by means of a CMOS transistor, and

wherein an output of said first pass-transistor circuit is supplied to one amplifier circuit of said driving circuits and an output of said second pass-transistor circuit is supplied to the other amplifier circuit of said driving circuits.

8. A logic circuit claimed in Claim 3 or 7 wherein a pull-up transistor is provided at each of input terminals for said second pair of complementary input logic signals for controlling the conducting conditions of the transistors constituting said first pass-transistor circuit and the conducting conditions of the transistors constituting said second pass-transistor circuit.

9. A logic circuit claimed in any one of Claims 3 to 8 wherein pull-up P-channel MOS field effect transistors are provided at an input terminal for a non-inverted signal of said second pair of complementary input logic signals and at an input terminal for an inverted signal of said second pair of complementary input logic signals, respectively, and the conducting condition of each of the P-channel type MOS field effect transistors is controlled by a signal complementary to the signal to be pulled up by said MOS field effect transistor itself.

10. A logic circuit claimed in Claims 3 to 9 wherein a pull-up transistor and a pull-down transistor are provided at input terminals for said second pair of complementary input logic signals for controlling the conducting conditions of the transistors constituting said first pass-transistor circuit and the conducting conditions of the transistors constituting said second pass-transistor circuit.

11. A logic circuit claimed in any one of Claims 3 to 9 wherein pull-up P-channel MOS field effect transistors and pull-down N-channel MOS field effect transistors are provided at an input terminal for a non-inverted signal of said second pair of complementary input logic signals and at an input terminal for an inverted signal of said second pair of complementary input logic signals, respectively, and wherein the respective conducting conditions of said P-channel type MOS field effect transistors and said N-channel MOS field effect transistors are controlled by a signal complementary to a signal to be pulled up or pulled down by said MOS field effect transistor itself.

12. A logic circuit comprising;

a first NMOS transistor having a source connected to a first input terminal, a second NMOS transistor having a source connected to a second input terminal, a third NMOS transistor having a source to said second input terminal and a fourth NMOS transistor having a source connected to said first input terminal, the gates of said first and third NMOS transistors being connected to a third input terminal and the gates of said second and fourth NMOS transistors being connected to a fourth input terminal,

a first NPN bipolar transistor having a collector connected to a first power supply terminal, a first PMOS transistor having a drain connected to a base of said first bipolar transistor, a fifth NMOS transistor having a drain connected to an emitter of said first bipolar transistor and a source connected to a second power supply terminal, a second NPN bipolar transistor having a collector connected to said first power supply terminal, a second PMOS transistor having a drain connected to a base of said bipolar transistor and a source connected to said first power supply terminal and a sixth NMOS transistor having a source connected to said power supply terminal;

wherein the drains of said first and second NMOS transistors and said first PMOS transistor and the gate of said second PMOS transistor are connected to form a first output terminal;

wherein the drains of said third and fourth NMOS transistors and said second PMOS transistor and the gate of said first PMOS transistors are connected to form a second output terminal;

wherein the emitter of said first bipolar transistor constitutes a third output terminal, and;

wherein the emitter of said second bipolar transistor constitutes a fourth output terminal.

13. A logic circuit comprising;

a first NMOS transistor having a source connected to a first input terminal, a second NMOS transistor having a source connected to a second input terminal, a third NMOS transistor having a source to said second input terminal and a fourth NMOS transistor having a source connected to said first input terminal, the gates of said first and third NMOS transistors being connected to a third input terminal and the gates of said second and fourth NMOS transistors being connected to a fourth input terminal,

a first NPN bipolar transistor having a collector connected to a first power supply terminal, a first PMOS transistor having a drain connected to a base of said first bipolar transistor and a source connected to said first power supply terminal, a second NPN bipolar transistor having a collector connected to an emitter of said first bipolar transistor and an emitter connected to a second power supply terminal, a fifth NMOS transistor having a drain connected to the emitter to said first bipolar transistor and a source connected to a base of said second NPN bipolar transistor, the source of said fifth NMOS transistor being connected through a first resistor to said second power supply terminal;

wherein it comprises a third NPN bipolar transistor having a collector connected to the first power supply terminal, a second PMOS transistor having a drain connected to a base of said third bipolar transistor and a source connected to said `first power supply terminal, a fourth NPN bipolar transistor having a collector connected to an emitter of said third bipolar transistor and an emitter connected to said second power supply terminal and a sixth NMOS transistor having a drain connected to the emitter to said third bipolar transistor and a source connected to a base of said fourth bipolar transistor, the source of said sixth NMOS transistor being connected through a second resistor to said second power supply terminal, the base of said first bipolar transistor being connected to the gate of said sixth NMOS transistor, and the base of said third bipolar transistor being connected to the gate of said fifth NMOS transistor;

wherein the drains of said first and second NMOS transistors and said first PMOS transistor and the gate of said second PMOS transistor are connected to form a first output terminal;

wherein the drains of said third and fourth NMOS transistors and said second PMOS transistor and the gate of said first PMOS transistors are connected to form a second output terminal;

wherein the emitter of said first bipolar transistor constitutes a third output terminal, and;

wherein the emitter of said second bipolar transistor constitutes a fourth output terminal.

14. A logic circuit comprising;

a first NMOS transistor having a source connected to a first input terminal, a second NMOS transistor having a source connected to a third input terminal, a third NMOS transistor having a source to a second input terminal and a fourth NMOS transistor having a source connected to a fourth input terminal, the gates of said first and third NMOS transistors being connected to said third input terminal and the gates of said second and fourth NMOS transistors being connected to said fourth input terminal,

a first NPN bipolar transistor having a collector connected to a first power supply terminal, a first PMOS transistor having a drain connected to a base of said first bipolar transistor and a source connected to said first power supply terminal, a fifth NMOS transistor having a drain connected to an emitter of said first bipolar transistor and a source connected to said second power supply terminal, a second NPN bipolar transistor having a collector connected to said first power supply terminal, a second PMOS transistor having a drain connected to a base of said second bipolar transistor and a source connected to said first power supply terminal and a sixth NMOS transistor having a drain connected to the emitter of said second bipolar transistor and a source connected to said second power supply terminal;

wherein the drains of said first and second NMOS transistors and said first PMOS transistor and the gate of said second PMOS transistor are connected to form a first output terminal;

wherein the drains of said third and fourth NMOS transistors and said second PMOS transistor and the gate of said first PMOS transistors are connected to form a second output terminal;

wherein the emitter of said first bipolar transistor constitutes a third output terminal, and;

wherein the emitter of said second bipolar transistor constitutes a fourth output terminal.

**15.** A logic circuit comprising;

a first NMOS transistor having a source connected to a first input terminal, a second NMOS transistor having a source connected to a third input terminal, a third NMOS transistor having a source to a second input terminal and a fourth NMOS transistor having a source connected to said fourth input terminal, the gates of said first and third NMOS transistors being connected to said third input terminal and the gates of said second and fourth NMOS transistors being connected to said fourth input terminal,

a first NPN bipolar transistor having a collector connected to a first power supply terminal, a first PMOS transistor having a drain connected to a base of said first bipolar transistor and a source connected to said first power supply terminal, a second NPN bipolar transistor having a collector connected to an emitter of said first bipolar transistor and an emitter connected to said second power supply terminal, a fifth NMOS transistor having a drain connected to the emitter to said first bipolar transistor and a source connected to the base of said second NPN bipolar transistor, the source of said fifth NMOS transistor being connected through a first resistor to said second power supply terminal;

a third NPN bipolar transistor having a collector connected to the first power supply terminal, a second PMOS transistor having a drain connected to the base of said third bipolar transistor and a source connected to said first power supply terminal, a fourth NPN bipolar transistor having a collector connected to an emitter of said third bipolar transistor and an emitter connected to said second power supply terminal, a sixth NMOS transistor having a drain connected to the emitter to said third bipolar transistor and a source connected to a base of said fourth bipolar transistor, the source of said sixth NMOS transistor being connected through a second resistor to said second power supply terminal, the base of said first bipolar transistor being connected to the gate of said sixth NMOS transistor, and the base of said third bipolar transistor being connected to the gate of said fifth NMOS transistor;

wherein the drains of said first and second NMOS transistors and said first PMOS transistor and tile gate of said second PMOS transistor are connected to form a first output terminal;

wherein the drains of said third and fourth NMOS transistors and said second PMOS transistor and the gate of said first PMOS transistors are connected to form a second output terminal;

wherein the emitter of said first bipolar transistor constitutes a third output terminal, and;

wherein the emitter of said third bipolar transistor constitutes a fourth output terminal.

EP 0 552 734 A2

# FIGURE 1A

# FIGURE 1B

| B | $\overline{B}$ | A | $\overline{A}$ | OUTPUT TERMINAL 5 $\overline{A \oplus B}$ | OUTPUT TERMINAL 8 $A \oplus B$ |
|---|---|---|---|---|---|
| 0 | 1 | 0 | 1 | $\overline{A} \begin{cases} 1 \\ 0 \end{cases}$ | $A \begin{cases} 0 \\ 1 \end{cases}$ |
| 0 | 1 | 1 | 0 | | |
| 1 | 0 | 0 | 1 | $A \begin{cases} 0 \\ 1 \end{cases}$ | $\overline{A} \begin{cases} 1 \\ 0 \end{cases}$ |
| 1 | 0 | 1 | 0 | | |

16

# FIGURE 2A

# FIGURE 2B

| B | $\overline{B}$ | A | $\overline{A}$ | OUTPUT TERMINAL 5 $A \cdot B$ | OUTPUT TERMINAL 8 $\overline{A \cdot B}$ |
|---|---|---|---|---|---|
| 0 | 1 | 0 | 1 | $B \left\{ \begin{array}{c} 0 \\ 0 \end{array} \right.$ | $\overline{B} \left\{ \begin{array}{c} 1 \\ 1 \end{array} \right.$ |
| 0 | 1 | 1 | 0 | | |
| 1 | 0 | 0 | 1 | $\overline{A} \left\{ \begin{array}{c} 0 \\ 1 \end{array} \right.$ | $A \left\{ \begin{array}{c} 1 \\ 0 \end{array} \right.$ |
| 1 | 0 | 1 | 0 | | |

# FIGURE 3A

# FIGURE 3B

| B | $\overline{B}$ | A | $\overline{A}$ | OUTPUT TERMINAL 5 | | OUTPUT TERMINAL 8 | |
|---|---|---|---|---|---|---|---|
| | | | | $A + B$ | | $\overline{A + B}$ | |
| 0 | 1 | 0 | 1 | $A \begin{cases} 0 \\ 1 \end{cases}$ | | $\overline{A} \begin{cases} 1 \\ 0 \end{cases}$ | |
| 0 | 1 | 1 | 0 | | | | |
| 1 | 0 | 0 | 1 | $B \begin{cases} 1 \\ 1 \end{cases}$ | | $\overline{B} \begin{cases} 0 \\ 0 \end{cases}$ | |
| 1 | 0 | 1 | 0 | | | | |

18

# FIGURE 4

# FIGURE 5

# FIGURE 6

# FIGURE 7